# NEUE EUROPÄISCHE PATENTSCHRIFT

(11) **EP 3 171 124 B2**
(45) Veröffentlichungstag und Bekanntmachung des Hinweises auf die Entscheidung über den Einspruch: **03.07.2024**
(45) Hinweis auf die Patenterteilung: 27.06.2018
(21) Anmeldenummer: 16195945.7
(22) Anmeldetag: 27.10.2016
(51) Int. Cl.: G01B 7/02, H03K 17/955

(54) **VERFAHREN FÜR DEN BETRIEB EINER KAPAZITIVEN SENSORANORDNUNG EINES KRAFTFAHRZEUGS**
METHOD OF OPERATING A CAPACITIVE SENSOR ASSEMBLY IN A MOTOR VEHICLE
PROCÉDÉ DE FONCTIONNEMENT D'UN SYSTÈME DE DÉTECTION CAPACITIF D'UN VÉHICULE AUTOMOBILE

(30) Priorität: 15.11.2015 DE 102015119701
(43) Veröffentlichungstag der Anmeldung: 24.05.2017
(73) Patentinhaber: Brose Fahrzeugteile GmbH & Co. Kommanditgesellschaft, Bamberg, 96052 Bamberg (DE)
(72) Erfinder: Würstlein, Holger, 97475 Zeil am Main (DE); Russ, Detlef, 96237 Ebersdorf (DE)
(74) Vertreter: Gottschald, Jan

(56) Entgegenhaltungen:
- WO-A1-99/28702
- DE-A1-102006 051 750
- DE-A1-102008 044 067
- DE-A1-102011 004 288
- DE-A1-102013 112 418
- DE-C1- 4 201 640
- DE-T2- 60 115 320
- DE-T5-112014 000 714
- FR-A5- 2 065 249
- US-A- 5 489 888
- US-A1- 2013 207 677
- US-A1- 2014 043 041

## Beschreibung

Die Erfindung betrifft ein Verfahren für den Betrieb einer kapazitiven Sensoranordnung eines Kraftfahrzeugs gemäß dem Oberbegriff von Anspruch 1, eine Steuereinheit zur Ansteuerung einer kapazitiven Sensoranordnung eines Kraftfahrzeugs gemäß dem Oberbegriff von Anspruch 13, sowie ein Sensorsystem eines Kraftfahrzeugs gemäß dem Oberbegriff von Anspruch 14.

Kapazitive Sensoranordnungen finden in verschiedenen Bereichen eines Kraftfahrzeugs Anwendung. Ein Beispiel ist die Erfassung eines Bedienereignisses, insbesondere einer Annäherung einer Person an das Kraftfahrzeug, was je nach Auslegung einen Authentifizierungsdialog auslösen kann. Ein anderes Beispiel ist die Erfassung einer drohenden Kollision zwischen einer Person und einer sich bewegenden Komponente, beispielsweise einer Heckklappe, des Kraftfahrzeugs.

Das in Rede stehende Verfahren betrifft den Betrieb einer kapazitiven Sensoranordnung eines Kraftfahrzeugs, die der Ermittlung von Abstandswerten zu einem Messobjekt dient. Hierfür ist der Sensoranordnung eine Steuereinheit zu deren Ansteuerung zugeordnet. Die Sensoranordnung weist zwei Elektroden auf, denen jeweils eine Anschlussanordnung für den Anschluss an die Steuereinheit zugeordnet ist. Der fehlerfreien Verbindung zwischen den Elektroden und der Steuereinheit kommt ganz besondere Bedeutung zu, um zu vermeiden, dass es beispielsweise aufgrund hoher Übergangswiderstände zu einer fehlerhaften Ermittlung von Abstandswerten kommt.

Bei dem bekannten Verfahren für den Betrieb einer kapazitiven Sensoranordnung eines Kraftfahrzeugs (DE 10 2013 112 418 A1), von dem die vorliegende Erfindung ausgeht, ist eine Diagnoseroutine vorgesehen, um den elektrischen Verbindungszustand der Elektrode im Hinblick auf die elektrische Verbindung zu der Steuereinheit zu überprüfen. Dabei geht die Überprüfung des elektrischen Verbindungszustands ganz allgemein auf eine Überprüfung des elektrischen Widerstands von Diagnosepfaden innerhalb der Sensoranordnung zurück. Das bekannte Verfahren ermöglicht zwar eine zuverlässige Erfassung von Fehlerzuständen. Allerdings erfordert das bekannte Verfahren stets die Kontaktierung der Elektroden mit jeweils zwei Verbindungsleitungen, um eine Überprüfung des betreffenden Widerstands durchführen zu können.
Weitere Verfahren für den Betrieb einer kapazitiven Sensoranordnung sind aus DE 10 2008 044 067 A1 und US 2013/0207677 A1 bekannt.

US2014/043041 A1 offenbart einen Schaltungsteil mit kapazitivem Verhalten, wobei der Verbindungszustand eines Drahtanschlusses in dem kapazitiven Element von einer Auswerteschaltung überprüft wird. Der Erfindung liegt das Problem zugrunde, das bekannte Verfahren derart auszugestalten und weiterzubilden, dass die Überprüfung des Verbindungszustands der jeweiligen Elektrode vereinfacht wird. Das obige Problem wird bei einem Verfahren gemäß dem Oberbegriff von Anspruch 1 durch die Merkmale des kennzeichnenden Teils von Anspruch 1 gelöst.

Wesentlich ist die grundsätzliche Überlegung, dass eine Veränderung der elektrischen Verbindung zwischen der betreffenden Elektrode und der Steuereinheit stets auch mit einer entsprechenden Veränderung der Größe und/oder des Ladeverhaltens der jeweiligen Eingangskapazität zwischen dem steuereinheitsseitigen Anschluss und dem Referenzpotential einhergeht. Dies liegt einerseits daran, dass die Zuleitung zu der Eingangskapazität durch eine fehlerhafte elektrische Verbindung einen erhöhten ohmschen Widerstand aufweisen kann, was das Ladeverhalten der Eingangskapazität beeinflusst. Andererseits kann eine elektrische Unterbrechung innerhalb der Elektrode oder innerhalb einer Verbindungsleitung dazu führen, dass sich die Größe der Eingangskapazität selbst verändert, meist reduziert. Beide Fehlerfälle lassen sich im Rahmen der Diagnoseroutine ganz allgemein erfassen, indem mittels der Steuereinheit der Verbindungszustand basierend auf der Eingangskapazität zwischen dem steuereinheitsseitigen Anschluss und dem Referenzpotential, insbesondere basierend auf dem kapazitiven Anteil der Eingangsimpedanz zwischen dem steuereinheitsseitigen Anschluss und dem Referenzpotential, überprüft wird. Besonders vorteilhaft ist dabei die Tatsache, dass sich die Eingangskapazität und damit der Verbindungszustand mit nur einer einzigen Verbindungsleitung überprüfen lässt, da die Eingangskapazität bzw. die Eingangsimpedanz gegenüber dem Referenzpotential, hier Massepotential, vorliegt.

Der Begriff "Anschluss" ist vorliegend weit zu verstehen. Er kann jeglichen Punkt in der Verbindung zwischen der Elektrode und der Steuereinheit betreffen. Ein Anschluss in diesem Sinne kann, muß aber nicht lösbar sein. Vorzugsweise ist der Anschluss jedoch ein steckbarer Anschluss. Entsprechend weit ist auch der Begriff "Anschlussanordnung" zu verstehen, dessen Anschlüsse an der Verbindungsleitung angeordnet oder indirekt, beispielsweise über elektrische Schaltungen, mit der Verbindungsleitung gekoppelt sein können.

Auch der Begriff "Steuereinheit" ist vorliegend weit zu verstehen. Bei der Steuereinheit kann es sich grundsätzlich um eine diskrete oder integrierte elektrische Steuerschaltung handeln, der verschiedene Steuerschaltungen vor- oder nachgeschaltet sein können.

Bei der bevorzugten Ausgestaltung gemäß Anspruch 4 wird im Rahmen der Diagnoseroutine überprüft, ob sich die Größe der Eingangskapazität bzw. der Eingangsimpedanz in einem vorbestimmten Zulässigkeitsbereich befindet. Hier kann seitens der Steuereinheit auf die bekannten Verfahren zur Erfassung der Größe einer Kapazität zurückgegriffen werden.

Es ist vorgesehen, dass im Rahmen der Diag- noseroutine die Reaktion der Sensoranordnung auf eine vorbestimmte Ansteuerung überprüft wird. Hier kann bei- spielsweise die Höhe des Ladestroms Aufschluss darü- ber geben, ob an irgendeiner Stelle der Anschlussanordnung fehlerhafterweise ein hochohmiger Übergang vorliegt.

Die Eingangskapazität der Sensoranordnung hängt in erster Linie von der Kapazität der jeweiligen Elektrode gegenüber Massepotential, aber auch von eventuellen, der Sensoranordnung zugeordneten Filterschaltkreisen gemäß Anspruch 3 ab. Entsprechend kann die Eingangskapazität unterschiedlichen Einflussfaktoren unterliegen. Insbesondere hat sich in der Praxis gezeigt, dass die Eingangskapazität oftmals einer nicht unbeachtlichen Temperaturdrift unterliegt. Das ist für die Ermittlung von Abstandswerten im Rahmen der Messroutine regelmäßig unbeachtlich, da sich die Abstandswerte vorzugsweise nur aus einer relativen Änderung der Kapazität der betreffenden Elektrode gegenüber dem Massepotential ergeben.

Um Einflussfaktoren wie eine Temperaturdrift der Eingangskapazität im Rahmen der Diagnoseroutine berücksichtigen zu können, ist bei den Ansprüchen 1 und 6 bis 10 eine Referenzschaltung vorgesehen, die im Rahmen der Diagnoseroutine gewissermaßen parallel zu der Sensoranordnung angesteuert wird.

Die Referenzschaltung ist gemäß Anspruch 8 in einer bevorzugten Variante so getroffen, dass die Referenzkapazität der Referenzschaltung eine im Wesentlichen identische Temperaturdrift wie die Eingangskapazität der Sensoranordnung aufweist, so dass im Rahmen der Diagnoseroutine über die Referenzschaltung eine Kompensation einer eventuellen Temperaturdrift der Eingangskapazität möglich ist.

Nach einer weiteren Lehre gemäß Anspruch 13, der eigenständige Bedeutung zukommt, wird eine Steuereinheit zur Ansteuerung einer obigen kapazitiven Sensoranordnung eines Kraftfahrzeugs zur Ermittlung eines Abstands zu einem Messobjekt als solche beansprucht. Die Steuereinheit ist insbesondere für die Durchführung des vorschlagsgemäßen Verfahrens ausgelegt. insoweit darf auf alle Ausführungen zu dem vorschlagsgemäßen Verfahren verwiesen werden.

Nach einer weiteren Lehre gemäß Anspruch 14, der ebenfalls eigenständige Bedeutung zukommt, wird ein Sensorsystem eines Kraftfahrzeugs mit mindestens einer kapazitiven Sensoranordnung zur Ermittlung eines Abstands zu einem Messobjekt und einer Steuereinheit zur Ansteuerung der Sensoranordnung als solches beansprucht. Auch dieses Sensorsystem ist insbesondere für die Durchführung des vorschlagsgemäßen Verfahrens ausgelegt, so dass wiederum auf alle Ausführungen zu dem vorschlagsgemäßen Verfahren verwiesen werden darf.

Im Folgenden wird die Erfindung anhand einer lediglich Ausführungsbeispiele darstellenden Zeichnung näher erläutert. In der Zeichnung zeigt
- Fig. 1: den Heckbereich eines Kraftfahrzeugs mit einem vorschlagsgemäßen Sensorsystem zur Durchführung des vorschlagsgemäßen Verfahrens mittels einer vorschlagsgemäßen Steuereinheit,
- Fig. 2: die Steuereinheit gemäß Fig. 1 mit daran angeschlossener Sensoranordnung in einer ganz schematischen Darstellung,
- Fig. 3: die Steuereinheit gemäß Fig. 2 mit angeschlossener Sensoranordnung in einem höheren Detailierungsgrad in einer ersten Ausführungsform und
- Fig. 4: die Steuereinheit gemäß Fig. 2 mit angeschlossener Sensoranordnung in einem höheren Detailierungsgrad in einer weiteren Ausführungsform.

Für die Durchführung des vorschlagsgemäßen Verfahrens ist eine kapazitive Sensoranordnung 1 eines Kraftfahrzeugs 2 vorgesehen, die der Ermittlung eines Abstands 3 zu einem Messobjekt, hier einem Bediener B, dient. Die Sensoranordnung 1 ist Bestandteil eines Steuersystems 4, das der Ansteuerung eines motorischen Verschlusselements 5 des Kraftfahrzeugs 2 dient. Das Steuersystem 4 ist hier und vorzugsweise dazu eingerichtet, Bedienereignisse zu erfassen und darauf basierend die Ansteuerung des motorischen Verschlusselements 5 vorzunehmen. Bei solchen Verschlusselementen kann es sich beispielsweise um Türen, wie Seiten- und Hecktüren, insbesondere Schiebetüren, Klappen, insbesondere Heckklappen, Heckdeckel, Motorhauben, Laderaumböden o. dgl. handeln. Insoweit ist der Begriff "Verschlusselement" vorliegend weit zu verstehen.

Hier und vorzugsweise handelt es sich bei dem motorischen Verschlusselement 5 um eine Heckklappe, die mit einem Heckklappenantrieb 6 ausgestattet ist.

Für die Erfassung eines Bedienereignisses, bei dem es sich beispielsweise um eine Fußbewegung des Bedieners B handeln kann, greift das Steuersystem 4 auf die von der Sensoranordnung 1 ermittelten Abstandswerte zurück.

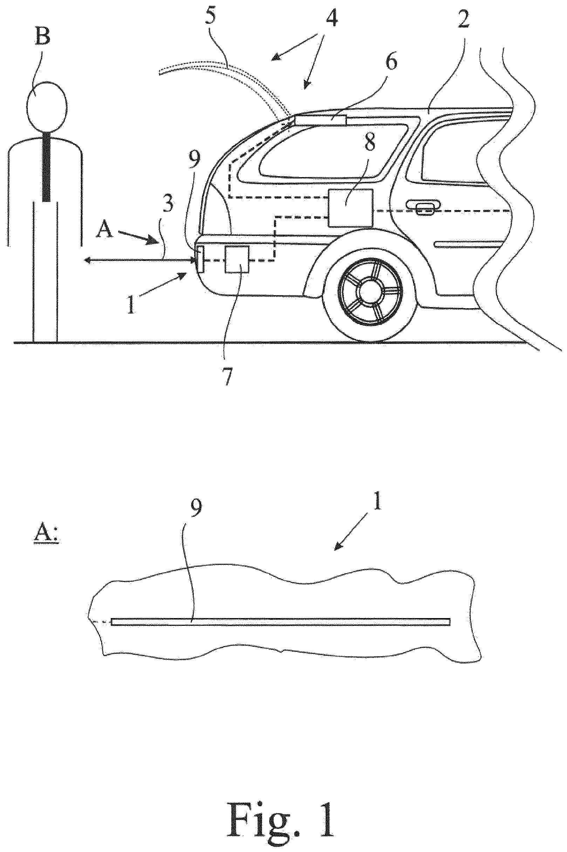

Zur Ansteuerung der Sensoranordnung 1 ist eine Steuereinheit 7 vorgesehen. Hier und vorzugsweise ist die Steuereinheit 7 im Sinne einer dezentralen Struktur separat von einer übergeordneten Steuerung 8 angeordnet. Die zentrale Steuerung 8 übernimmt bei dem in Fig. 1 dargestellten Ausführungsbeispiel in Abhängigkeit von Steuersignalen der Steuereinheit 7 die Ansteuerung des Heckklappenantriebs 6. Die Steuereinheit 7 kann grundsätzlich aber auch Bestandteil der zentralen Steuerung 8 sein.

Die Sensoranordnung 1 weist mindestens eine Elektrode 9 auf, die hier und vorzugsweise länglich ausgestaltet ist. Die Elektrode 9 verläuft vorzugsweise entlang des Verschlusselements 5 und ist weiter vorzugsweise in oder an einem Karosseriebauteil, insbesondere einem Stoßfänger, angeordnet. Im Folgenden ist stets die Rede von lediglich einer Elektrode 9. Alle diesbezüglichen Ausführungen gelten für alle weiteren, eventuell vorgesehenen Elektroden entsprechend.

Für den elektrischen Anschluss der Elektrode 9 an die Steuereinheit 7 ist der Elektrode 9 eine Anschlussanordnung 10 zugeordnet, die eine Verbindungsleitung 11 und mit der Verbindungsleitung 11 gekoppelt einen elektrodenseitigen Anschluss 12 und einen steuereinheitsseitigen Anschluss 13 aufweist.

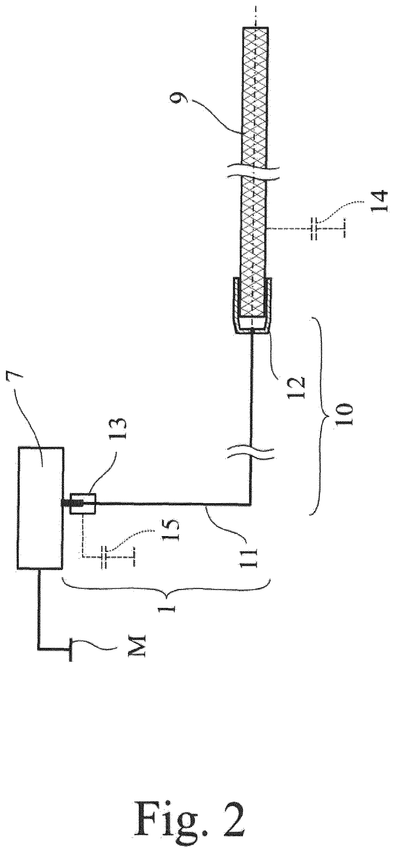

Im Rahmen einer Messroutine wird mittels der Steuereinheit 7 die Elektrode 9 angesteuert, wobei die resultierenden Abstandswerte in Abhängigkeit von einer von der Elektrode 9 gegenüber einem Referenzpotential, insbesondere gegenüber Massepotential M, gebildeten Messkapazität ermittelt werden. Die Messkapazität, die von der Elektrode 9 bereitgestellt wird und deren Größe sich bei Annäherung des jeweiligen Messobjekts B verändert, ist in Fig. 2 in gestrichelter Linie lediglich angedeutet und mit dem Bezugszeichen 14 versehen. Die im Rahmen der Messroutine ermittelten Abstandswerte werden im Rahmen der oben angesprochenen Bedienereignisüberwachung genutzt.

Die Überprüfung des elektrischen Verbindungszustands der Elektrode 9 steht vorliegend im Vordergrund. Dabei umfasst der Verbindungszustand den Zustand der Anschlüsse 12, 13, den Zustand der Verbindungsleitung 11 sowie den Zustand der Elektrode 9. Es soll überprüft werden, ob diese Komponenten sich überhaupt in einem leitfähigen Zustand befinden und insbesondere, ob sich beispielsweise durch unzureichende Anschlussverbindungen hohe Übergangswiderstände ergeben.

Für die Überprüfung des Verbindungszustands der Elektrode 9 ist eine Diagnoseroutine vorgesehen, die mittels der Steuereinheit 7 vollzogen wird. Wesentlich ist, dass im Rahmen der Diagnoseroutine mittels der Steuereinheit 7 der Verbindungszustand basierend auf der Eingangskapazität zwischen dem steuereinheitsseitigen Anschluss 13 und dem Referenzpotential, hier dem Massepotential M, überprüft wird. Die Eingangskapazität ist in Fig. 2 ebenfalls in gestrichelter Linie lediglich angedeutet und mit dem Bezugszeichen 15 versehen. Es handelt sich bei der Eingangskapazität 15 also um die Kapazität eingangsseitig der Sensoranordnung 1.

Vorschlagsgemäß ist, wie oben angesprochen, erkannt worden, dass sich eine Veränderung des Verbindungszustands der Elektrode 9 auf die Größe und das Ladeverhalten der Eingangskapazität 15 zwischen dem steuereinheitsseitigen Anschluss 13 und dem Massepotential M, also auf die Eingangsimpedanz 15a zwischen dem steuereinheitsseitigen Anschluss 13 und dem Massepotential M, auswirkt.

Vorschlagsgemäß ist es nicht unbedingt erforderlich, im Rahmen der Diagnoseroutine die Eingangskapazität 15 als solche wertemäßig zu ermitteln. Im Rahmen der vorschlagsgemäßen Lehre geht es darum, den Einfluss einer Veränderung des Verbindungszustands auf die Größe und das Ladeverhalten der Eingangskapazität 15 für die Überprüfung des Verbindungszustands zu nutzen.

Die Diagnoseroutine wird vorzugsweise zyklisch vorgenommen. In besonders bevorzugter Ausgestaltung wird die Diagnoseroutine aber triggerbasiert, also bei Auftreten eines vorbestimmten Triggerereignisses, vorgenommen.

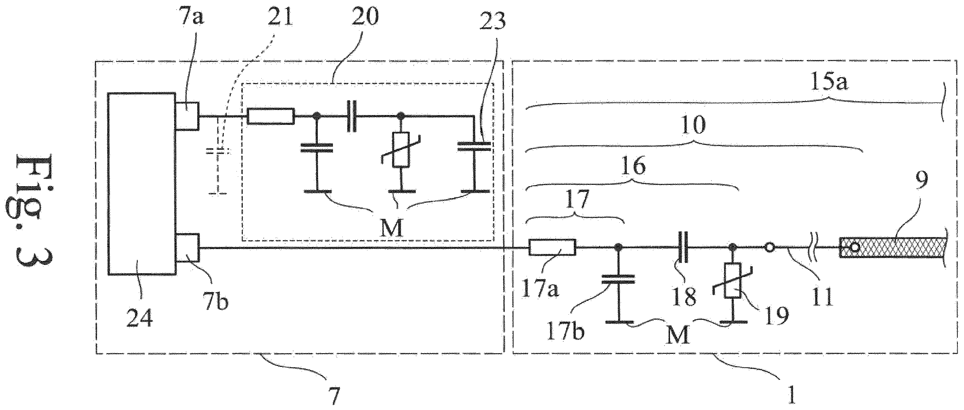

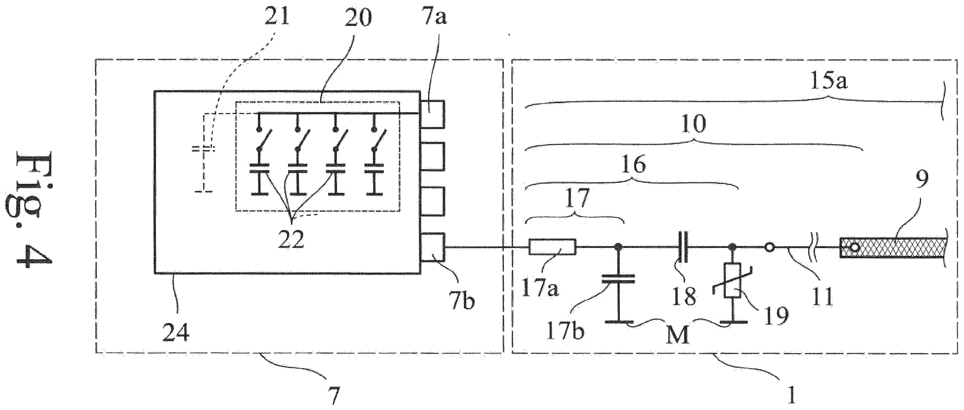

Bei der Eingangskapazität 15 handelt es sich hier und vorzugsweise um den kapazitiven Anteil der entsprechenden Eingangsimpedanz 15a zwischen dem steuereinheitsseitigen Anschluss 13 und dem Referenzpotential. Die Eingangsimpedanz 15a ist in den Fig. 3 und 4 lediglich angedeutet.

Die Fig. 3 und 4 zeigen, dass die Sensoranordnung 1, hier zwischen der Steuereinheit 7 und der Anschlussanordnung 10, einen Filterschaltkreis 16 aufweist. Der Filterschaltkreis 16 kann auch in der Anschlussanordnung 10 vorgesehen sein. Grundsätzlich können hier auch mehrere Filterschaltkreise 16 vorgesehen sein. Hier und vorzugsweise weist der Filterschaltkreis einen Tiefpassfilter 17 bestehend aus einem Widerstand 17a und einer Kapazität 17b auf. Ferner ist der Filterschaltkreis 16 mit einem Entkoppelkondensator 18 zur Entkopplung der Steuereinheit 7 von eventuell auf die Elektrode 9 geschalteter Gleichspannungsanteile ausgestattet. Schließlich weist der Filterschaltkreis 16 ein ESD-Schutzelement (Electro Static Discharge Schutzelement) 19 auf, bei dem es sich vorliegend um einen Varistor oder um eine Schutzdiode handelt, der gegen Massepotential M geschaltet ist.

Grundsätzlich kann es vorgesehen sein, dass ein Fehler-Verbindungszustand mittels der Steuereinheit 7 dadurch erfasst wird, dass sich die Eingangskapazität 15, insbesondere die Eingangsimpedanz 15a und weiter insbesondere deren kapazitiver Anteil, in einer vorbestimmten Weise verändert.

Im Einzelnen kann es vorteilhaft sein, dass sich die Eingangskapazität 15 und/oder die Eingangsimpedanz 15a bei fehlerfreiem Soll-Verbindungszustand der Elektrode 9 in einem vorbestimmten Zulässigkeitsbereich befindet. Der Zulässigkeitsbereich kann durch die Größe der Eingangskapazität 15 in einem vorbestimmten Temperaturbereich der Umgebungstemperatur des Kraftfahrzeugs 2 definiert sein. Dabei ist es vorzugsweise vorgesehen, dass sich die Eingangskapazität 15 und/oder die Eingangsimpedanz 15a bei einem Fehler-Verbindungszustand, beispielsweise bei einem Kabelbruch in der Verbindungsleitung 11, außerhalb des Zulässigkeitsbereichs, hier unterhalb des Zulässigkeitsbereichs, befindet. Dies wird mittels der Steuereinheit 7 entsprechend als Fehler-Verbindungszustand erfasst. Hierfür wird von der Steuereinheit 7 in einer bevorzugten Variante die Eingangskapazität 15 ermittelt und zur Ermittlung des Verbindungszustands der Elektrode 9 mit dem Zulässigkeitsbereich für die Eingangskapazität 15 verglichen. Für die Ermittlung der Eingangskapazität 15 zwischen dem steuereinheitsseitigen Anschluss 13 und dem Massepotential M sind verschiedene, schaltungstechnisch leicht umsetzbare Varianten bekannt.

Es ist vorgesehen, dass im Rahmen der Diagnoseroutine die Sensoranordnung 1 mittels der Steuereinheit 7, also über den steuereinheitsseitigen Anschluss 13, mit einer Diagnosespannung und/oder mit einem Diagnosestrom angesteuert wird, wobei aus dem resultierenden Diagnosestrom bzw. der resultierenden Diagnosespannung auf den Verbindungszustand der Elektrode 9 geschlossen wird. In diesem Rahmen ist es denkbar, dass sich ein hoher Übergangswiderstand beispielsweise beim elektrodenseitigen Anschluss 12 in einem relativ kleinen Ladestrom bei der Ansteuerung der Anschlussanordnung 10 mit einer Diagnosespannung auswirkt. Dieser kleine Ladestrom kann von der Steuereinheit 7 als Fehlerzustand erfasst werden.

Die Fig. 3 und 4 zeigen, dass die dortigen Steuereinheiten 7 jeweils eine Referenzschaltung 20 umfassen. Hier ist es vorgesehen, dass im Rahmen der Diagnoseroutine zur Ermittlung des Verbindungszustands der Elektrode 9 mittels der Steuereinheit 7 sowohl die Referenzschaltung 20 als auch die Sensoranordnung 1 mit einer Diagnosespannung oder einem Diagnosestrom angesteuert werden. Hierfür weist die Steuereinheit 7 entsprechend ansteuerbare Messports 7a, 7b für die Referenzschaltung 20 einerseits und für die Anschlussanordnung 10 andererseits auf, die sowohl der Ansteuerung der Referenzschaltung 20 mit Spannungen und/oder Strömen und der Sensoranordnung 1, als auch der Erfassung der resultierenden Messströme bzw. Messspannungen dienen. Insoweit handelt es sich bei den Messports 7a jeweils sowohl um einen Messausgang als auch um einen Messeingang.

Aus den resultierenden Messströmen bzw. Messspannungen wird wie oben angesprochen auf den Verbindungszustand der Elektrode 9 geschlossen. Dabei werden die resultierenden Messströme bzw. Messspannungen die einerseits der Referenzschaltung 20 und andererseits der Anschlussanordnung 10 zugeordnet sind, miteinander korrelliert, um auf den Verbindungszustand der Elektrode 9 schließen zu können. Der Begriff "korreliert" umfasst vorliegend jegliche Verarbeitung der betreffenden Messströme bzw. Messspannungen miteinander, die Aufschluss über eine vorbestimmte Relation zwischen der jeweiligen Größe von Referenzschaltung 20 und Sensoranordnung 1 gibt. Hier werden die resultierenden Messströme bzw. Messspannungen in dem Rahmen der Korrelation miteinander verglichen.

Eine steuerungstechnisch besonders einfache Ausgestaltung ergibt sich dadurch, dass im Rahmen der Diagnoseroutine mittels der Steuereinheit 7 die Referenzschaltung 20 und die Sensoranordnung 1 identisch angesteuert werden. Diese identische Ansteuerung kann gleichzeitig oder zeitversetzt erfolgen. In ganz besonders bevorzugter Ausgestaltung ist diese Ansteuerung identisch zu der Ansteuerung der Sensoranordnung 1 im Rahmen der Messroutine. Letztlich ist es also so, dass die Steuereinheit 7 die Referenzschaltung 20 einerseits und die Sensoranordnung 1 andererseits jeweils ansteuert, um Abstandswerte zu einem Messobjekt B zu ermitteln. In einer bevorzugten Ausgestaltung ist es entsprechend vorgesehen, dass die Steuereinheit 7 im Rahmen der Diagnoseroutine tatsächlich die Abstandswerte ermittelt und zur Ermittlung des Verbindungszustands verarbeitet, insbesondere miteinander vergleicht.

Es darf darauf hingewiesen werden, dass der Begriff "Diagnosespannung" vorliegend weit zu verstehen ist und einen Spannungssprung, einen Spannungsimpuls oder eine Wechselspannung umfassen kann. Wesentlich ist lediglich, dass die Diagnosespannung eine Veränderung umfasst, so dass mindestens ein Lade- bzw. Entladevorgang der Eingangskapazität 15 erfasst werden kann. Auch der Begriff "Diagnosestrom" ist weit zu verstehen. Er umfasst entsprechend einen Stromsprung, einen Stromimpuls oder einen Wechselstrom.

Die Referenzschaltung 20 stellt zumindest zu einem gewissen Grad eine schaltungstechnische Nachbildung der Sensoranordnung 1 dar. Entsprechend ist es vorgesehen, dass die Referenzschaltung 20 eine Referenzkapazität, hier und vorzugsweise gegenüber Massepotential M, bereitstellt, die zumindest in einem Betriebsbereich im Wesentlichen identisch zu der Eingangskapazität 15 ist. Vorzugsweise ist es so, dass die Referenzschaltung eine Impedanz aufweist, die zumindest in einem Betriebsbereich im Wesentlichen identisch zu der Eingangsimpedanz 15a der Sensoranordnung ist.

Bei der in Fig. 3 gezeigten Referenzschaltung 20 handelt es sich bei der Referenzkapazität 21 um die resultierende, am Eingang der Referenzschaltung 20 gegenüber Massepotential M vorliegende Kapazität, die in Fig. 3 in gestrichelter Linie dargestellt ist. Bei dem in Fig. 4 dargestellten und insoweit bevorzugten Ausführungsbeispiel ist die Referenzkapazität 21 die Summe der in Fig. 4 dargestellten, über die Schaltelemente 22a jeweils aktivierten Einzelkapazitäten 22, wie noch erläutert wird.

In besonders bevorzugter Ausgestaltung ist die Anordnung nun so getroffen, dass die Referenzkapazität 21 der Referenzschaltung 20 zumindest über einen vorbestimmten Temperaturbereich der Umgebungstemperatur des Kraftfahrzeugs 2 eine im Wesentlichen identische Temperaturdrift wie die Eingangskapazität 15 aufweist. Damit kann sichergestellt werden, dass Temperatureffekte keinen Einfluss auf die Ermittlung des Verbindungszustands der Elektrode 9 haben.

Im einfachsten Fall ist es so, dass im Rahmen der Diagnoseroutine mittels der Steuereinheit 7 aus dem Unterschied zwischen der Referenzkapazität 21 der Referenzschaltung 20 und der Eingangskapazität 15 auf den Verbindungszustand der Elektrode 9 geschlossen wird. Der Begriff "Unterschied" ist hier weit zu verstehen. Er umfasst beispielsweise eine Differenz zwischen der Referenzkapazität 21 und der Eingangskapazität 15. Er umfasst in einer weiteren bevorzugten Variante aber auch ein Verhältnis zwischen der Referenzkapazität 21 und der Eingangskapazität 15.

Bei der besonders bevorzugten Ausgestaltung gemäß Fig. 3 umfasst die Referenzschaltung 20 neben einer Nachbildung des Filterschaltkreises 16 auch eine Nachbildung der Messkapazität 14. Zusätzlich kann die Referenzschaltung 20 auch eine schaltungstechnische Nachbildung der Anschlussanordnung 10 umfassen (nicht dargestellt). Bei der in Fig. 4 dargestellten Ausgestaltung ist es dagegen so, dass die Referenzschaltung 20 lediglich eine Nachbildung der Messkapazität 14 umfasst, die sich dann aus der Summe der über die Schaltelemente 22a jeweils aktivierten Einzelkapazitäten 22 ergibt.

Grundsätzlich kann die Referenzschaltung 20 als Referenz-Schwingkreis (nicht dargestellt) ausgestaltet sein, wobei im Rahmen der Diagnoseroutine mittels der Steuereinheit 7 die Sensoranordnung 1 in den Referenz-Schwingkreis geschaltet wird. Der Referenz-Schwingkreis ist vorzugsweise so ausgestaltet, dass eine Veränderung der Eingangskapazität 15 mit einer Verstimmung des Referenz-Schwingkreises einhergeht. Dabei ist es vorzugsweise vorgesehen, dass mittels der Steuereinheit 7 eine resultierende Verstimmung des Referenz-Schwingkreises ermittelt wird und daraus auf den Verbindungszustand der Elektrode 9 geschlossen wird.

Grundsätzlich kann es vorgesehen sein, dass die Referenzschaltung 20, hier und vorzugsweise die Referenzkapazität 21, parametrierbar ist. Dies ist in Fig. 4 durch die mehreren Einzelkapazitäten 22 vorgesehen, die jeweils durch ein Schaltelement 22a zu der resultierenden Referenzkapazität 21 zusammengeschaltet werden können. Damit ist es ohne Weiteres möglich, dass im Rahmen einer Lernroutine die Eingangskapazität 15 der Sensoranordnung 1 ermittelt und die Referenzschaltung 20 daraufhin parametriert wird. Dies ist besonders einfach, wenn, wie in den Fig. 3 und 4 dargestellt, die Steuereinheit 7 ein integriertes Bauelement 24 mit einer Recheneinheit zur Ermittlung des Verbindungszustands der Elektrode 9 aufweist. Dadurch, dass bei der in Fig. 4 gezeigten Ausgestaltung die Referenzschaltung 20 Bestandteil des integrierten Bauelements 24 ist, lässt sich die Referenzkapazität 21 auf einfache Weise softwaremäßig einstellen.

Auch die Verbindung der Referenzkapazität 21 mit dem Messport 7a lässt sich dann softwaremäßig einstellen.

Bei der in Fig. 3 dargestellten und insoweit bevorzugten Ausgestaltung ist es jedoch so, dass die Referenzschaltung 20 separat von dem integrierten Bauelement 24 als diskreter Schaltkreis ausgestaltet ist, was insoweit vorteilhaft ist, als sich dadurch eine besonders hohe Flexibilität bei der oben angesprochenen, schaltungstechnischen Nachbildung der Sensoranordnung 1 ergibt. Es darf in diesem Zusammenhang darauf hingewiesen werden, dass der Filterschaltkreis 16 vorliegend zwar der Sensoranordnung 1 zugeordnet ist, allerdings in der konkreten Realisierung auf einer Leiterplatte der Steuereinheit 7 angeordnet sein kann.

Nach einer weiteren Lehre, der eigenständige Bedeutung zukommt, wird die oben angesprochene Steuereinheit 7 zur Ansteuerung der kapazitiven Sensoranordnung 1 als solche beansprucht. Auf alle obigen Ausführungen zu der Steuereinheit 7 darf verwiesen werden.

Nach einer weiteren Lehre, der ebenfalls eigenständige Bedeutung zukommt, wird das Sensorsystem 4 eines Kraftfahrzeugs 4 mit der mindestens einen kapazitiven Sensoranordnung 1 als solches beansprucht. Auf alle Ausführungen zu der Sensoranordnung 1 und der Steuereinheit 7 darf wiederum verwiesen werden.

## Patentansprüche

1. Verfahren für den Betrieb einer kapazitiven Sensoranordnung (1) eines Kraftfahrzeugs (2) zur Ermittlung eines Abstands (3) zu einem Messobjekt (B), wobei eine Steuereinheit (7) zur Ansteuerung der Sensoranordnung (1) vorgesehen ist, wobei die Sensoranordnung (1) mindestens eine Elektrode (9) und eine der Elektrode (9) zugeordnete Anschlussanordnung (10) mit einer Verbindungsleitung (11) und damit gekoppelt einem elektrodenseitigen Anschluss (12) und einem steuereinheitsseitigen Anschluss (13) aufweist, wobei im Rahmen einer Messroutine mittels der Steuereinheit (7) die Elektrode (9) angesteuert wird und die resultierenden Abstandswerte in Abhängigkeit von einer von der Elektrode (9) gegenüber einem Referenzpotential, insbesondere gegenüber Massepotential (M), gebildeten Messkapazität (14) ermittelt werden, wobei im Rahmen einer Diagnoseroutine mittels der Steuereinheit (7) der elektrische Verbindungszustand der Elektrode (9) im Hinblick auf die Verbindung zu der Steuereinheit (7) überprüft wird,
**dadurch gekennzeichnet,**
**dass** im Rahmen der Diagnoseroutine mittels der Steuereinheit (7) der Verbindungszustand basierend auf der Eingangskapazität (15) zwischen dem steuereinheitsseitigen Anschluss (13) und dem Referenzpotential überprüft wird und dass die Steuereinheit (7) eine Referenzschaltung (20) umfasst, dass im Rahmen der Diagnoseroutine zur Ermittlung des Verbindungszustands der Elektrode (9) mittels der Steuereinheit (7) die Referenzschaltung (20) und die Sensoranordnung (1) mit einer Diagnosespannung oder einem Diagnosestrom angesteuert werden und dass aus den resultierenden Meßströmen bzw. Meßspannungen auf den Verbindungszustand der Elektrode (9) geschlossen wird, indem die resultierenden Meßströme bzw. Meßspannungen miteinander verglichen werden, und dass die Referenzschaltung (20) eine Referenzkapazität (21), insbesondere gegenüber dem Referenzpotential, bereitstellt, die zumindest in einem Betriebsbereich im Wesentlichen identisch zu der Eingangskapazität (15) ist.

2. Verfahren nach Anspruch 1, **dadurch gekennzeichnet, dass** die Eingangskapazität der kapazitive Anteil der Eingangsimpedanz (15a) zwischen dem steuereinheitsseitigen Anschluss (13) und dem Referenzpotential ist.

3. Verfahren nach Anspruch 1 oder 2, **dadurch gekennzeichnet, dass** die Sensoranordnung (1), insbesondere zwischen der Steuereinheit (7) und der Anschlussanordnung (10) oder in der Anschlussanordnung (10), mindestens einen Filterschaltkreis (16) aufweist, vorzugsweise, dass der Filterschaltkreis (16) einen Tiefpassfilter (17) und/oder einen Entkoppelkondensator (18) und/oder ein ESD-Schutzelement (19) aufweist.

4. Verfahren nach einem der vorhergehenden Ansprüche, **dadurch gekennzeichnet, dass** sich die Eingangskapazität (15) und/oder die Eingangsimpedanz (15a) bei fehlerfreiem Soll-Verbindungszustand in einem vorbestimmten Zulässigkeitsbereich befindet, dass sich die Eingangskapazität (15) bzw. die Eingangsimpedanz (15a) zwischen dem steuereinheitsseitigen Anschluss (13) und dem Referenzpotential bei einem Fehler-Verbindungszustand außerhalb des Zulässigkeitsbereichs befindet und dass der Verbindungszustand mittels der Steuereinheit (7) bei außerhalb des Zulässigkeitsbereichs befindlicher Eingangskapazität (15) bzw. Eingangsimpedanz (15a) als Fehler-Verbindungszustand erfasst wird.

5. Verfahren nach Anspruch 4, **dadurch gekennzeichnet, dass** mittels der Steuereinheit (7) die Eingangskapazität (15) oder die Eingangsimpedanz (15a) ermittelt und zur Ermittlung des Verbindungszustands mit dem Zulässigkeitsbereich für die Eingangskapazität (15) bzw. für die Eingangsimpedanz (15a) verglichen wird.

6. Verfahren nach einem der vorhergehenden Ansprüche, **dadurch gekennzeichnet, dass** im Rahmen der Diagnoseroutine mittels der Steuereinheit (7) die Referenzschaltung (20) und die Sensoranordnung (1) identisch angesteuert werden, vorzugsweise, dass diese Ansteuerung identisch zu der Ansteuerung der Sensoranordnung (1) im Rahmen der Messroutine ist.

7. Verfahren nach einem der einem der vorhergehenden Ansprüche, **dadurch gekennzeichnet, dass** die Diagnosespannung ein Spannungssprung oder ein Spannungsimpuls oder eine Wechselspannung ist, oder, dass der Diagnosestrom ein Stromsprung oder ein Stromimpuls oder ein Wechselstrom ist.

8. Verfahren nach einem der vorhergehenden Ansprüche, **dadurch gekennzeichnet, dass** die Referenzkapazität (21) der Referenzschaltung (20) eine im Wesentlichen identische Temperaturdrift wie die Eingangskapazität (15) aufweist.

9. Verfahren nach einem der vorhergehenden Ansprüche, **dadurch gekennzeichnet, dass** im Rahmen der Diagnoseroutine mittels der Steuereinheit (7) aus dem Unterschied zwischen der Referenzkapazität (21) der Referenzschaltung (20) und der Eingangskapazität (15), insbesondere einer Differenz oder einem Verhältnis, auf den Verbindungszustand der Elektrode (9) geschlossen wird.

10. Verfahren nach einem der vorhergehenden Ansprüche, **dadurch gekennzeichnet, dass** die Referenzschaltung (20) ein Referenz-Schwingkreis ist und dass im Rahmen der Diagnoseroutine mittels der Steuereinheit (7) die Sensoranordnung (1) in den Referenz-Schwingkreis geschaltet wird, vorzugsweise, dass mittels der Steuereinheit (7) eine resultierende Verstimmung des Referenz-Schwingkreises ermittelt wird und daraus auf den Verbindungszustand der Elektrode (9) geschlossen wird.

11. Verfahren nach einem der vorhergehenden Ansprüche, **dadurch gekennzeichnet, dass** die Referenzschaltung (20), insbesondere die Referenzkapazität (21), parametrierbar ist, vorzugsweise, dass im Rahmen einer Lernroutine die Eingangskapazität (15) ermittelt und die Referenzschaltung (20) daraufhin parametriert wird.

12. Verfahren nach einem der vorhergehenden Ansprüche, **dadurch gekennzeichnet, dass** die Steuereinheit (7) ein integriertes Bauelement (24) mit einer Recheneinheit zur Ermittlung des Verbindungszustands der Elektrode (9) aufweist, vorzugsweise, dass die Referenzschaltung (20) separat von dem integrierten Bauelement (24) als diskreter Schaltkreis ausgestaltet ist, oder, dass die Referenzschaltung (20) Bestandteil des integrierten Bauelements (24) ist.

13. Steuereinheit zur Ansteuerung einer kapazitiven Sensoranordnung (1) eines Kraftfahrzeugs (2) zur Ermittlung eines Abstands (3) zu einem Messobjekt (B), wobei die Sensoranordnung (1) mindestens eine Elektrode (9) und eine der Elektrode (9) zugeordnete Anschlussanordnung (10) mit einer Verbindungsleitung (19) und damit gekoppelt einem elektrodenseitigen Anschluss (12) und einem steuereinheitsseitigen Anschluss (13) aufweist, wobei im Rahmen einer Messroutine die Steuereinheit (7) die Elektrode (9) ansteuert und die resultierenden Abstandswerte in Abhängigkeit von einer von der Elektrode (9) gegenüber einem Referenzpotential, insbesondere gegenüber Massepotential (M), gebildeten Messkapazität (14) ermittelt, wobei im Rahmen einer Diagnoseroutine die Steuereinheit (7) den elektrischen Verbindungszustand der Elektrode (9) im Hinblick auf die Verbindung zu der Steuereinheit (7) überprüft,
**dadurch gekennzeichnet,**
**dass** im Rahmen der Diagnoseroutine die Steuereinheit (7) den Verbindungszustand basierend auf der Eingangskapazität (15) zwischen dem steuereinheitsseitigen Anschluss (13) und dem Referenzpotential überprüft und dass die Steuereinheit (7) eine Referenzschaltung (20) umfasst, dass im Rahmen der Diagnoseroutine zur Ermittlung des Verbindungszustands der Elektrode (9) mittels der Steuereinheit (7) die Referenzschaltung (20) und die Sensoranordnung (1) mit einer Diagnosespannung oder einem Diagnosestrom angesteuert werden und dass aus den resultierenden Meßströmen bzw. Meßspannungen auf den Verbindungszustand der Elektrode (9) geschlossen wird, indem die resultierenden Meßströme bzw. Meßspannungen miteinander verglichen werden, und dass die Referenzschaltung (20) eine Referenzkapazität (21), insbesondere gegenüber dem Referenzpotential, bereitstellt, die zumindest in einem Betriebsbereich im Wesentlichen identisch zu der Eingangskapazität (15) ist.

14. Sensorsystem eines Kraftfahrzeugs mit mindestens einer kapazitiven Sensoranordnung (1) zur Ermittlung eines Abstands (3) zu einem Messobjekt (B) und einer Steuereinheit (7) zur Ansteuerung der Sensoranordnung (1), wobei die Sensoranordnung (1) mindestens eine Elektrode (9) und eine der Elektrode (9) zugeordnete Anschlussanordnung (10) mit einer Verbindungsleitung (11) und damit gekoppelt einem elektrodenseitigen Anschluss (12) und einem steuereinheitsseitigen Anschluss (13) aufweist, wobei im Rahmen einer Messroutine die Steuereinheit (7) die Elektrode (9) ansteuert und die resultierenden Abstandswerte in Abhängigkeit von einer von der Elektrode (9) gegenüber einem Referenzpotential, insbesondere gegenüber Massepotential (M), gebildeten Messkapazität (14) ermittelt, wobei im Rahmen einer Diagnoseroutine die Steuereinheit (7) den elektrischen Verbindungszustand der Elektrode (9) im Hinblick auf die Verbindung zu der Steuereinheit (7) überprüft,
**dadurch gekennzeichnet,**
**dass** im Rahmen der Diagnoseroutine die Steuereinheit (7) den Verbindungszustand basierend auf der Eingangskapazität (15) zwischen dem steuereinheitsseitigen Anschluss (13) und dem Referenzpotential überprüft und dass die Steuereinheit (7) eine Referenzschaltung (20) umfasst, dass im Rahmen der Diagnoseroutine zur Ermittlung des Verbindungszustands der Elektrode (9) mittels der Steuereinheit (7) die Referenzschaltung (20) und die Sensoranordnung (1) mit einer Diagnosespannung oder einem Diagnosestrom angesteuert werden und dass aus den resultierenden Meßströmen bzw. Meßspannungen auf den Verbindungszustand der Elektrode (9) geschlossen wird, indem die resultierenden Meßströme bzw. Meßspannungen miteinander verglichen werden, und dass die Referenzschaltung (20) eine Referenzkapazität (21), insbesondere gegenüber dem Referenzpotential, bereitstellt, die zumindest in einem Betriebsbereich im Wesentlichen identisch zu der Eingangskapazität (15) ist.

## Claims

1. Method for operating a capacitive sensor arrangement (1) of a motor vehicle (2) for determining a distance (3) to a measurement object (B), a control unit (7) for controlling the sensor arrangement (1) being provided, the sensor arrangement (1) having at least one electrode (9) and a connection arrangement (10) which is assigned to the electrode (9) and has a connecting line (11) and, in a manner coupled to the latter, a connection (12) on the electrode side and a connection (13) on the control unit side, the electrode (9) being controlled during a measurement routine by means of the control unit (7) and the resulting distance values being determined on the basis of a measurement capacitance (14) formed by the electrode (9) with respect to a reference potential, in particular with respect to earth potential (M), the electrical connection state of the electrode (9) being checked with respect to the connection to the control unit (7) during a diagnostic routine by means of the control unit (7),
**characterized**
**in that** the connection state is checked during the diagnostic routine by means of the control unit (7) on the basis of the input capacitance (15) between the connection (13) on the control unit side and the reference potential, and in that the control unit (7) comprises a reference circuit (20), in that the reference circuit (20) and the sensor arrangement (1) are controlled with a diagnostic voltage or a diagnostic current by means of the control unit (7) during the diagnostic routine for determining the connection state of the electrode (9), and in that the connection state of the electrode (9) is inferred from the resulting measurement currents or measurement voltages by comparing the resulting measurement currents or measurement voltages with one another, and in that the reference circuit (20) provides a reference capacitance (21), in particular with respect to the reference potential, which is substantially identical to the input capacitance (15) at least in an operating range.

2. Method according to Claim 1, **characterized in that** the input capacitance is the capacitive portion of the input impedance (15a) between the connection (13) on the control unit side and the reference potential.

3. Method according to Claim 1 or 2, **characterized in that** the sensor arrangement (1) has at least one filter circuit (16), in particular between the control unit (7) and the connection arrangement (10) or in the connection arrangement (10), preferably **in that** the filter circuit (16) has a low-pass filter (17) and/or a decoupling capacitor (18) and/or an ESD protective element (19).

4. Method according to one of the preceding claims, **characterized in that** the input capacitance (15) and/or the input impedance (15a) is/are in a predetermined permissibility range in the case of a fault-free desired connection state, **in that** the input capacitance (15) or the input impedance (15a) between the connection (13) on the control unit side and the reference potential is outside the permissibility range in the case of a faulty connection state, and **in that** the connection state is detected as a faulty connection state by means of the control unit (7) if the input capacitance (15) or input impedance (15a) is outside the permissibility range.

5. Method according to Claim 4, **characterized in that** the input capacitance (15) or the input impedance (15a) is determined by means of the control unit (7) and is compared with the permissibility range for the input capacitance (15) or for the input impedance (15a) in order to determine the connection state.

6. Method according to one of the preceding claims, **characterized in that** the reference circuit (20) and the sensor arrangement (1) are controlled in an identical manner during the diagnostic routine by means of the control unit (7), preferably **in that** this control is identical to the control of the sensor arrangement (1) during the measurement routine.

7. Method according to one of the preceding claims, **characterized in that** the diagnostic voltage is a voltage jump or a voltage pulse or an AC voltage, or **in that** the diagnostic current is a current step or a current pulse or an alternating current.

8. Method according to one of the preceding claims, **characterized in that** the reference capacitance (21) of the reference circuit (20) has a substantially identical temperature drift to the input capacitance (15) .

9. Method according to one of the preceding claims, **characterized in that** the connection state of the electrode (9) is inferred from the difference between the reference capacitance (21) of the reference circuit (20) and the input capacitance (15), in particular a difference or a ratio, during the diagnostic routine by means of the control unit (7).

10. Method according to one of the preceding claims, **characterized in that** the reference circuit (20) is a reference resonant circuit, and **in that** the sensor arrangement (1) is connected into the reference resonant circuit during the diagnostic routine by means of the control unit (7), preferably **in that** resulting detuning of the reference resonant circuit is determined by means of the control unit (7) and is used to infer the connection state of the electrode (9).

11. Method according to one of the preceding claims, **characterized in that** the reference circuit (20), in particular the reference capacitance (21), can be parameterized, preferably **in that** the input capacitance (15) is determined during a learning routine and the reference circuit (20) is then parameterized.

12. Method according to one of the preceding claims, **characterized in that** the control unit (7) has an integrated component (24) with a computing unit for determining the connection state of the electrode (9), preferably **in that** the reference circuit (20) is in the form of a discrete circuit separate from the integrated component (24), or **in that** the reference circuit (20) is part of the integrated component (24).

13. Control unit for controlling a capacitive sensor arrangement (1) of a motor vehicle (2) for determining a distance (3) to a measurement object (B), the sensor arrangement (1) having at least one electrode (9) and a connection arrangement (10) which is assigned to the electrode (9) and has a connecting line (19) and, in a manner coupled to the latter, a connection (12) on the electrode side and a connection (13) on the control unit side, the control unit (7) controlling the electrode (9) during a measurement routine and determining the resulting distance values on the basis of a measurement capacitance (14) formed by the electrode (9) with respect to a reference potential, in particular with respect to earth potential (M), the control unit (7) checking the electrical connection state of the electrode (9) with regard to the connection to the control unit (7) during a diagnostic routine,
**characterized**
**in that** the control unit (7) checks the connection state during the diagnostic routine on the basis of the input capacitance (15) between the connection (13) on the control unit side and the reference potential, and in that the control unit (7) comprises a reference circuit (20), in that the reference circuit (20) and the sensor arrangement (1) are controlled with a diagnostic voltage or a diagnostic current by means of the control unit (7) during the diagnostic routine for determining the connection state of the electrode (9), and in that the connection state of the electrode (9) is inferred from the resulting measurement currents or measurement voltages by comparing the resulting measurement currents or measurement voltages with one another, and in that the reference circuit (20) provides a reference capacitance (21), in particular with respect to the reference potential, which is substantially identical to the input capacitance (15) at least in an operating range.

14. Sensor system of a motor vehicle having at least one capacitive sensor arrangement (1) for determining a distance (3) to a measurement object (B) and having a control unit (7) for controlling the sensor arrangement (1), the sensor arrangement (1) having at least one electrode (9) and a connection arrangement (10) which is assigned to the electrode (9) and has a connecting line (11) and, in a manner coupled to the latter, a connection (12) on the electrode side and a connection (13) on the control unit side, the control unit (7) controlling the electrode (9) during a measurement routine and determining the resulting distance values on the basis of a measurement capacitance (14) formed by the electrode (9) with respect to a reference potential, in particular with respect to earth potential (M), the control unit (7) checking the electrical connection state of the electrode (9) with regard to the connection to the control unit (7) during a diagnostic routine,
**characterized**
**in that** the control unit (7) checks the connection state during the diagnostic routine on the basis of the input capacitance (15) between the connection (13) on the control unit side and the reference potential, and in that the control unit (7) comprises a reference circuit (20), in that the reference circuit (20) and the sensor arrangement (1) are controlled with a diagnostic voltage or a diagnostic current by means of the control unit (7) during the diagnostic routine for determining the connection state of the electrode (9), and in that the connection state of the electrode (9) is inferred from the resulting measurement currents or measurement voltages by comparing the resulting measurement currents or measurement voltages with one another, and in that the reference circuit (20) provides a reference capacitance (21), in particular with respect to the reference potential, which is substantially identical to the input capacitance (15) at least in an operating range.

## Revendications

1. Procédé de fonctionnement d'un ensemble de capteurs capacitifs (1) d'un véhicule automobile (2) pour déterminer une distance (3) à un objet de mesure (B), une unité de commande (7) étant prévue pour commander l'ensemble de capteurs (1), l'ensemble de capteurs (1) comportant au moins une électrode (9) et un ensemble de bornes (10) associé à l'électrode (9) et comprenant une ligne de liaison (11) et une borne côté électrode (12) couplée à celle-ci et une borne côté unité de commande (13), dans le cadre d'une routine de mesure l'électrode (9) étant commandée au moyen de l'unité de commande (7) et les valeurs de distance résultantes étant déterminées en fonction d'une capacité de mesure (14) formée par l'électrode (9) par rapport à un potentiel de référence, notamment par rapport au potentiel de masse (M), dans le cadre d'une routine de diagnostic l'état de liaison électrique de l'électrode (9) étant vérifié au moyen de l'unité de commande (7) en ce qui concerne la liaison à l'unité de commande (7),
**caractérisé en ce que**
dans le cadre de la routine de diagnostic l'état de liaison est vérifié au moyen de l'unité de commande (7) sur la base de la capacité d'entrée (15) entre la borne côté unité de commande (13) et le potentiel de référence et **en ce que** l'unité de commande (7) comprend un circuit de référence (20), dans le cadre de la routine de diagnostic pour déterminer l'état de liaison de l'électrode (9) au moyen de l'unité de commande (7), le circuit de référence (20) et l'ensemble de capteurs (1) sont commandés avec une tension de diagnostic ou un courant de diagnostic et **en ce que** l'état de liaison de l'électrode (9) est déduit à partir des courants de mesure résultants ou des tensions de mesure résultantes par comparaison des courants de mesure résultants entre eux ou des tensions de mesure résultantes entre elles et **en ce que** le circuit de référence (20) fournit une capacité de référence (21), en particulier par rapport au potentiel de référence, qui est sensiblement identique à la capacité d'entrée (15), au moins dans une zone de fonctionnement.

2. Procédé selon la revendication 1, **caractérisé en ce que** la capacité d'entrée est la composante capacitive de l'impédance d'entrée (15a) entre la borne côté unité de commande (13) et le potentiel de référence.

3. Procédé selon la revendication 1 ou 2, **caractérisé en ce que** l'ensemble de capteurs (1) comporte, en particulier entre l'unité de commande (7) et l'ensemble de bornes (10) ou dans l'ensemble de bornes (10), au moins un circuit de filtrage (16), de préférence, **en ce que** le circuit de filtrage (16) comporte un filtre passe-bas (17) et/ou un condensateur de découplage (18) et/ou un élément de protection ESD (19).

4. Procédé selon l'une des revendications précédentes, **caractérisé en ce que** la capacité d'entrée (15) et/ou l'impédance d'entrée (15a) se trouve dans une zone admissible prédéterminée lorsque l'état de liaison cible est non défectueux, **en ce que** la capacité d'entrée (15) ou l'impédance d'entrée (15a) se trouve à l'extérieur de la zone admissible entre la borne côté unité de commande (13) et le potentiel de référence lorsqu'un état de liaison est défectueux et **en ce que** l'état de liaison est détecté comme état de liaison défectueux au moyen de l'unité de commande (7) lorsque la capacité d'entrée (15) ou l'impédance d'entrée (15a) se trouve à l'extérieur de la zone admissible.

5. Procédé selon la revendication 4, **caractérisé en ce que** la capacité d'entrée (15) ou l'impédance d'entrée (15a) est déterminée au moyen de l'unité de commande (7) et, pour déterminer l'état de liaison, est comparée à la zone admissible pour la capacité d'entrée (15) ou pour l'impédance d'entrée (15a).

6. Procédé selon l'une des revendications précédentes, **caractérisé en ce que**, dans le cadre de la routine de diagnostic, le circuit de référence (20) et l'ensemble de capteurs (1) sont commandés de manière identique au moyen de l'unité de commande (7), de préférence **en ce que** cette commande est identique à la commande de l'ensemble de capteurs (1) dans le cadre de la routine de mesure.

7. Procédé selon l'une des revendications précédentes, **caractérisé en ce que** la tension de diagnostic est un saut de tension ou une impulsion de tension ou une tension alternative, ou **en ce que** le courant de diagnostic est un saut de courant ou une impulsion de courant ou un courant alternatif.

8. Procédé selon l'une des revendications précédentes, **caractérisé en ce que** la capacité de référence (21) du circuit de référence (20) présente une dérive en température sensiblement identique à celle de la capacité d'entrée (15).

9. Procédé selon l'une des revendications précédentes, **caractérisé en ce que**, dans le cadre de la routine de diagnostic, l'état de liaison de l'électrode (9) est déduit au moyen de l'unité de commande (7) à partir de la différence entre la capacité de référence (21) du circuit de référence (20) et la capacité d'entrée (15), notamment d'une différence ou d'un rapport.

10. Procédé selon l'une des revendications précédentes, **caractérisé en ce que** le circuit de référence (20) est un circuit résonant de référence et **en ce que**, dans le cadre de la routine de diagnostic, l'ensemble de capteurs (1) est commuté au moyen de l'unité de commande (7) dans le circuit résonant de référence, de préférence **en ce qu'**un désaccord résultant du circuit résonant de référence est déterminé au moyen de l'unité de commande (7) et l'état de liaison de l'électrode (9) est déduit à partir de celui-ci.

11. Procédé selon l'une des revendications précédentes, **caractérisé en ce que** le circuit de référence (20), notamment la capacité de référence (21), peut être paramétré, de préférence **en ce que** la capacité d'entrée (15) est déterminée dans le cadre d'une routine d'apprentissage et **en ce que** le circuit de référence (20) est ensuite paramétré.

12. Procédé selon l'une des revendications précédentes, **caractérisé en ce que** l'unité de commande (7) comporte un composant intégré (24) comprenant une unité de calcul destinée à déterminer l'état de liaison de l'électrode (9), de préférence **en ce que** le circuit de référence (20) est conçu comme un circuit discret séparément du composant intégré (24) ou **en ce que** le circuit de référence (20) fait partie du composant intégré (24).

13. Unité de commande destinée à commander un ensemble de capteurs capacitifs (1) d'un véhicule automobile (2) afin de déterminer une distance (3) à un objet de mesure (B), l'ensemble de capteurs (1) comportant au moins une électrode (9) et un ensemble de bornes (10) associé à l'électrode (9) et comprenant une ligne de liaison (19) et une borne côté électrode (12) couplée à ladite liaison et une borne côté unité de commande (13), dans le cadre d'une routine de mesure l'unité de commande (7) commandant l'électrode (9) et déterminant les valeurs de distance résultantes en fonction d'une capacité de mesure (14) formée par l'électrode (9) par rapport à un potentiel de référence, notamment par rapport au potentiel de masse (M), dans le cadre d'une routine de diagnostic l'unité de commande (7) vérifiant l'état de liaison électrique de l'électrode (9) en ce qui concerne la liaison à l'unité de commande (7),
**caractérisée en ce que**
dans le cadre de la routine de diagnostic l'unité de commande (7) vérifie l'état de liaison sur la base de la capacité d'entrée (15) entre la borne côté unité de commande (13) et le potentiel de référence et **en ce que** l'unité de commande (7) comprend un circuit de référence (20), **en ce que** dans le cadre de la routine de diagnostic le circuit de référence (20) et l'ensemble de capteurs (1) sont commandés avec une tension de diagnostic ou un courant de diagnostic afin de déterminer l'état de liaison de l'électrode (9) au moyen de l'unité de commande (7) et **en ce que** l'état de liaison de l'électrode (9) est déduit à partir des courants de mesure résultants ou des tensions de mesure résultantes par comparaison des courants de mesure résultants entre eux ou des tensions de mesure résultantes entre elles, et **en ce que** le circuit de référence (20) fournit une capacité de référence (21), notamment par rapport au potentiel de référence, qui est sensiblement identique à la capacité d'entrée (15), au moins dans une zone de fonctionnement.

14. Système de capteurs d'un véhicule automobile comprenant au moins un ensemble de capteurs capacitifs (1) destiné à déterminer une distance (3) à un objet de mesure (B) et une unité de commande (7) destinée à commander l'ensemble de capteurs (1), l'ensemble de capteurs (1) comportant au moins une électrode (9) et un ensemble de bornes (10) associé à l'électrode (9) et comprenant une ligne de liaison (11) et une borne côté électrode (12) couplée à ladite ligne de liaison et une borne côté unité de commande (13), dans le cadre d'une routine de mesure l'unité de commande (7) commandant l'électrode (9) et déterminant les valeurs de distance résultantes en fonction d'une capacité de mesure (14) formée par l'électrode (9) par rapport à un potentiel de référence, notamment par rapport au potentiel de masse (M), dans le cadre d'une routine de diagnostic l'unité de commande (7) vérifiant l'état de liaison électrique de l'électrode (9) en ce qui concerne la liaison à l'unité de commande (7),
**caractérisé en ce que**
dans le cadre de la routine de diagnostic l'unité de commande (7) vérifie l'état de liaison sur la base de la capacité d'entrée (15) entre la borne côté unité de commande (13) et le potentiel de référence et **en ce que** l'unité de commande (7) comprend un circuit de référence (20), **en ce que** dans le cadre de la routine de diagnostic le circuit de référence (20) et l'ensemble de capteurs (1) sont commandés avec une tension de diagnostic ou un courant de diagnostic au moyen de l'unité de commande (7) afin de déterminer l'état de liaison de l'électrode (9) et **en ce que** l'état de liaison de l'électrode (9) est déduit à partir des courants de mesure résultants ou des tensions de mesure résultantes par comparaison des courants de mesure résultants entre eux ou des tensions de mesure résultantes entre elles, et **en ce que** le circuit de référence (20) fournit une capacité de référence (21), en particulier par rapport au potentiel de référence, qui est sensiblement identique à la capacité d'entrée (15) au moins dans une zone de fonctionnement.
